(19) Europäisches Patentamt
European Patent Office
Office européen des brevets

(11) **EP 1 319 092 B2**

(12) **NOUVEAU FASCICULE DE BREVET EUROPEEN**
Après la procédure d'opposition

(45) Date de publication et mention de la décision concernant l'opposition:
**17.04.2013 Bulletin 2013/16**

(45) Mention de la délivrance du brevet:
**21.06.2006 Bulletin 2006/25**

(21) Numéro de dépôt: **01972163.8**

(22) Date de dépôt: **19.09.2001**

(51) Int Cl.:
*C23C 14/08* (2006.01) *C03C 17/34* (2006.01)
*G02B 1/11* (2006.01)

(86) Numéro de dépôt international:
**PCT/FR2001/002906**

(87) Numéro de publication internationale:
**WO 2002/024971 (28.03.2002 Gazette 2002/12)**

(54) **SUBSTRAT A REVETEMENT PHOTOCATALYTIQUE**

SUBSTRAT MIT EINER PHOTOKATALYTISCHEN BESCHICHTUNG

SUBSTRATE WITH PHOTOCATALYTIC COATING

(84) Etats contractants désignés:
**AT BE CH CY DE DK ES FI FR GB GR IE IT LI LU MC NL PT SE TR**

(30) Priorité: **20.09.2000 FR 0011959**

(43) Date de publication de la demande:
**18.06.2003 Bulletin 2003/25**

(60) Demande divisionnaire:
**06112782.5 / 1 679 389**

(73) Titulaire: **SAINT-GOBAIN GLASS FRANCE**
**92400 Courbevoie (FR)**

(72) Inventeurs:
• **NADAUD, Nicolas**
  **F-94250 Gentilly (FR)**
• **TALPAERT, Xavier**
  **F-75019 Paris (FR)**
• **RONDEAU, Véronique**
  **B-1410- WATERLOO (BE)**

(74) Mandataire: **Teyssedre, Laurent et al**
**Saint-Gobain Recherche**
**39, quai Lucien Lefranc**
**B.P. 135**
**93303 Aubervilliers Cedex (FR)**

(56) Documents cités:
EP-A- 0 901 991      EP-A1- 1 319 092
EP-A2- 0 967 008      WO-A-00/27771
WO-A-97/10186        WO-A-98/41480
US-A- 5 332 618        US-A- 6 027 766
US-A- 6 103 363

• EXARHOS G J ET AL: "Raman characterization of all-dielectric multilayer SiO/sub 2//TiO/sub 2/ optical coatings" APPLIED OPTICS, 15 JUNE 1984, USA, vol. 23, no. 12, pages 1986-1988, XP000997003 ISSN: 0003-6935
• HUIYAO WANG ET AL: "Effects of substrate temperature on the microstructure and photocatalytic reactivity of TiO/sub 2/ films" JOURNAL OF MATERIALS SCIENCE: MATERIALS IN ELECTRONICS, OCT. 1998, KLUWER ACADEMIC PUBLISHERS/CHAPMAN & HALL, USA, vol. 9, no. 5, pages 327-330, XP000824174 ISSN: 0957-4522
• WANG TIANMIN ET AL: "The effect of properties of semiconductor oxide thin films on photocatalytic decomposition of dyeing waste water" SYMPOSIUM Q ON THIN FILMS, IUMRS-ICA-97, MAKUHARI, JAPAN, 16-18 SEPT. 1997, vol. 334, no. 1-2, pages 103-108, XP000669264 Thin Solid Films, 4 Dec. 1998, Elsevier, Switzerland ISSN: 0040-6090
• LI-JIAN MENG ET AL: "THE EFFECT OF SUBSTRATE TEMPERATURE ON THE PROPERTIES OF D.C. REACTIVE MAGNETRON SPUTTERED TITANIUM OXIDE FILMS" THIN SOLID FILMS,CH,ELSEVIER-SEQUOIA S.A. LAUSANNE, vol. 223, no. 2, 15 février 1993 (1993-02-15), pages 242-247, XP000360767 ISSN: 0040-6090
• PATENT ABSTRACTS OF JAPAN vol. 1999, no. 09, 30 juillet 1999 (1999-07-30) & JP 11 092176 A (BRIDGESTONE CORP), 6 avril 1999 (1999-04-06)

EP 1 319 092 B2

• PETROV I ET AL: "Ion-assisted growth of Ti1-xAlxN/Ti1-yNbyN multilayers by combined cathodic-arc/magnetron-sputter deposition" THIN SOLID FILMS, ELSEVIER-SEQUOIA S.A. LAUSANNE, CH, vol. 302, no. 1-2, 20 juin 1997 (1997-06-20), pages 179-192, XP004115521 ISSN: 0040-6090

• PATENT ABSTRACTS OF JAPAN vol. 1998, no. 12, 31 octobre 1998 (1998-10-31) & JP 10 196229 A (DAINIPPON PRINTING CO LTD), 28 juillet 1998 (1998-07-28)

**Description**

L'invention concerne des substrats généralement transparents ou semi-transparents, notamment en verre, en matériau plastique, en vitrocéramique, et qu'on munit de revêtement à propriétés photocatalytiques pour leur conférer une fonction anti-salissures ou, plus exactement, auto-nettoyante.

Une application importante de ces substrats concerne des vitrages, qui peuvent être d'applications très diverses, des vitrages utilitaires aux vitrages utilisés, dans l'électroménager, des vitrages pour véhicules aux vitrages pour bâtiments.

Elle s'applique aussi aux vitrages réfléchissants du type miroir (miroir pour habitations ou rétroviseur de véhicule) et aux vitrages opacifiés du type allège.

L'invention s'applique aussi, similairement, aux substrats non transparentes, comme des substrats de céramique ou tout autre substrat pouvant notamment être utilisé comme matériau architectural (métal, carrelages ...). Elle s'applique de préférence, quelle que soit la nature du substrat, à des substrats sensiblement plans ou légèrement bombés.

Les revêtements photocatalytiques ont déjà été étudiés, notamment creux à base d'oxyde de titane cristallisé sous forme anatase. Leur capacité à dégrader les salissures d'origine organique ou les micro-organismes sous l'effet de rayonnement U.V. est très intéressante. Ils ont aussi souvent un caractère hydrophile, qui permet l'évacuation des salissures minérales par projection d'eau ou, pour les vitrages extérieurs, par la pluie.

Ce type de revêtement aux propriétés anti-salissures, bactéricides, algicides, a déjà été décrit, notamment dans le brevet WO97/10186, qui en décrit plusieurs modes d'obtention.

L'invention a alors pour but d'améliorer les techniques de dépôt de ce type de revêtement, notamment en vue de les simplifier. Parallèlement, elle a également pour but d'améliorer l'aspect du revêtement, plus particulièrement d'améliorer les propriétés optiques du substrat qui en est muni.

L'invention a tout d'abord pour objet un procédé de dépôt par pulvérisation cathodique d'un revêtement à propriétés photocatalytiques ne comprenant que de l'oxyde de titane au moins partiellement cristallisé sous forme anatase sur un substrat porteur transparent ou semi-transparent. La caractéristique de l'invention consiste à réaliser la pulvérisation sur le substrat, sous une pression de dépôt d'au moins 2 Pascals. Elle est d'au plus 6,67 Pa et notamment d'au moins 2,67 Pa (c'est-à-dire au moins 15 millitors, notamment entre 20 et 50 millitors). La pulvérisation est réalisée à température ambiante et le dépôt du revêtement est suivi par un traitement thermique de type recuit afin d'obtenir la cristallisation du revêtement.

En effet, comme cela est connu du brevet WO97/10186 précité, on peut déposer ce type de revêtement par pulvérisation cathodique. C'est une technique sous vide qui permet, notamment, d'ajuster très fixement les épaisseurs et la stoechiométrie des couches déposées. Elle est généralement assistée par champ magnétique pour plus d'efficacité. Elle peut être réactive : on part alors d'une cibler essentiellement métallique, ici à base de titane (éventuellement allié à un autre métal ou à du silicium), et la pulvérisation se fait en atmosphère oxydante, généralement un mélangé. $Ar/O_2$. Elle peut aussi être non réactive, on part alors d'une cible dite céramique qui est déjà sous la forme oxydée du titane (éventuellement alliée).

Cependant, les couches obtenues par ce type de technique sont généralement amorphes, alors que la fonctionnalité du revêtement selon l'invention est directement liée au fait qu'il doit être significativement cristallisé. C'est la raison pour laquelle, comme cela est préconisé dans le brevet précité, on a besoin de cristalliser (ou d'augmenter le taux de cristallisation) du revêtement en lui faisant subir un traitement thermique, par exemple de l'ordre de 30 minutes à plusieurs heures à au moins 400°C.

Il a été montré selon l'invention qu'une pression aussi élevée favorisait une cristallisation particulière de la couche, un niveau de densité/de rugosité qui avaient un impact significatif sur le niveau des propriétés photocatalytiques du revêtement. Pour donner un ordre d'idée, les pressions de dépôt généralement utilisées pour des oxydes métalliques sont usuellement dans la gamme des 2 à 8 millitors (soit 0,27 à 1,07 Pa) : l'invention choisit donc des pressions de dépôt tout-à-fait inhabituelles dans ce domaine.

Généralement, quand le revêtement est essentiellement à base d'oxyde de titane ($TiO_2$), et quand on le dépose par pulvérisation cathodique, il a un indice de réfraction assez élevé, supérieur à 2 ou à 2,1 ou à 2,15 ou 2,2. Il est généralement compris entre 2,15 et 2,35 ou entre 2,35 et 2,50 (il peut être légèrement sous-stoechiométrique), notamment entre 2,40 et 2,45. C'est une caractéristique assez spécifique de ce type dé dépôt, car des revêtements de même nature déposés par d'autres techniques, par exemple par sol-gel, tendent à être beaucoup plus poreux et à avoir des indices de réfraction significativement moins élevés (en dessous de 2 et même en dessous de 1,8 ou 1,7). L'invention permet d'obtenir des couches par pulvérisation cathodique qui présentent une porosité et/ou une rugosité (notamment une rugosité RMS comprise entre 2,5 et 10 nm amplifiant ses propriétés photocatalytiques. De ce fait, elles peuvent présenter des indices de réfraction de l'ordre de 2,15 ou 2,35, inférieures à ceux habituellement obtenus par pulvérisation cathodique, preuve indirecte de leur, porosité. C'est un atout sur le plan optique, puisqu'elles ont, avec un indice de réfraction abaissé, un aspect moins réfléchissant à épaisseur donnée.

Il a été observé que la structure cristallographique des revêtements est influencée par le fait qu'ils sont déposés à froid puis recuits. Ainsi, de manière assez inattendue, les revêtements déposés à haute pression, conformément à l'invention ont généralement une taille moyenne de cristallites de $TiO_2$ généralement inférieure ou égale à 50 ou à 40 ou à 30 nm, notamment comprise entre 15 et 30 nm ou entre 20 et 40 nm. Les revêtements déposés de façon standard, notamment " à froid" puis recuits, tendent à comporter des cristallites de taille supérieure, d'au moins 30 nm ou 40, généralement comprise entre 40 est 50 nm quand on utilise des pressions de dépôt standard.

Par contre, si, selon l'invention, on dépose le revêtement à température ambiante mais à haute pression, et que l'on fait ensuite une opération de recuit, la taille des cristallites est de taille plus faible (20-40 nm), et comparable à celle des cristallites des revêtements déposés à chaud, que ce soit à haute ou basse pression.

L'activité photocatalytique des revêtements déposés à température ambiante à haute pression puis recuits est bien meilleure que celle des revêtements déposés à température ambiante à basse pression, puis recuits : toutes choses égales par ailleurs, il est clair que la pression de dépôt influe sur les performances du revêtement, tout particulièrement en cas de dépôt " à froid ", et cela de façon marquante.

Un chauffage simultané avec la croissance de la couche entraîne la formation d'une micro-structure propice à une rugosité et/ou une porosité favorable à une propriété photocatalytique. C'est un peu le même cas quand on utilise une pression de dépôt élevée (avec un dépôt à " froid " suivi d'un recuit par exemple).

Grâce au procédé selon l'invention (par dépôt à pression élevée), on peut obtenir des revêtements présentant une rugosité R.M.S. (Root Mean Square) mesurée par microscopie à force atomique, en faisant des mesures sur une même surface avec des pas de 2 micromètres :

- d'au moins 2 nm, notamment d'au moins 2,5 nm, de préférence entre 2,8 nm et 4,6 nm dans le cas de dépôts à température ambiante à haute pression au sens de l'invention (2 à 5 Pa), suivis de recuits,
- d'au moins 4 nm, notamment d'au moins 5 nm, de préférence entre 5,5 et 6,0 nm dans le cas de dépôt à chaud (environ 250°C) sans recuit, que ce soit à haute ou basse pression.

A titre de comparaison, la rugosité de revêtements déposés à température ambiante à pression standard (notamment 2.10-3 millibars, soit 0,2 Pa) puis recuits n'est que de 2 nm au mieux : cela prouve que l'utilisation de pressions élevées permet d'atteindre des rugosités étonnamment élevées pour des couches déposées par pulvérisation cathodique, ce qui a pour conséquence une amélioration des propriétés photocatalytiques du revêtement.

Avantageusement, le revêtement a une épaisseur géométrique inférieure à 150 nm, notamment comprise entre 80 et 120 nm ou entre 10 et 25 nm. Il s'est avéré que, même très mince, le revêtement pouvait présenter des propriétés photocatalytiques suffisantes (au moins pour certaines applications), avec en outre l'avantage optique d'être peu réfléchissant.

Comme on l'a vu plus haut, la pulvérisation cathodique du revêtement peut être réactive ou non réactive.

Le procédé de dépôt selon l'invention peut être précédé et/ou suivi d'une ou plusieurs étapes de dépôt d'autre(s) couche(s) mince(s), notamment à fonction optique, anti-statique, anti-couleur, anti-réfléchissante, hydrophile, protectrice, ou pour amplifier la rugosité du revêtement à propriétés photocatalytiques. On a ainsi observé que l'on peut avoir avantage à déposer une (au moins) couche de façon à ce qu'elle soit particulièrement rugueuse, par exemple par pyrolyse ou sol-gel, puis le revêtement photocatalytique ; le revêtements trend alors à "suivre" la rugosité de la couche sous-jacente et à présente de fait, lui aussi, une rugosité significative, alors que les couches déposés par pulvérisation cathodique ont plutôt tendance à être peu rugueuses. On peut ainsi faire des empilements avec une sous-couche (de rugosité R.M.S. de par exemple au moins 5 ou 10 nm), de type $SiO_2$ SiOC ou SiON déposée par pyrolyse en phase gazeuse (CVD), puis la couche photocatalytique par pulvérisation cathodique.

L'invention comprend donc toute combinaison entre le dépôt d'une ou plusieurs couches pair pulvérisation cathodique (dont le revêtement photocatalytique au moins) et le dépôt de la ou des autres couches, de l'empilement par une technique impliquant une décomposition thermique, notamment une pyrolyse (en phase liquide, gazeuse ou pulvérulente) ou une technique par sol-gel.

Comme on l'a vu plus haut, les revêtements à base de $TiO_2$ photocatalytique ont un indice de réfraction élevé. Cela signifie qu'ils sont réfléchissants et qu'ils confèrent à leur substrat porteur un aspect réfléchissant considéré souvent comme peu esthétique. En outre, la couleur en réflexion, mis à part ce caractère brillant, peut être indésirable. Il n'est pas simple d'améliorer cet aspect en réflexion, car la fonctionnalité photocatalytique présente des contraintes : Le revêtement doit généralement être au contact de l'atmosphère extérieure pour recevoir des U.V. et dégrader les salissures extérieures. On ne peut donc pas le surmonter d'une couche à bas indice (à moins qu'elle soit très mince et/ou poreuse). Il doit aussi avoir une épaisseur minimale donnée pour être suffisamment efficace.

L'invention a également pour objet le vitrage, notamment un vitrage simple (un substrat rigide), un vitrage feuilleté, un vitrage multiple du type double vitrage et qui comporte au moins un substrat revêtu de la façon décrite plus haut.

Le vitrage peut comporter aussi un ou plusieurs autres revêtements fonctionnels (déposés par pulvérisation cathodique ou pyrolyse ou sol-gel), soit sur la même face du substrat muni du revêtement photocatalytique, soit sur la face opposée de ce substrat, soit sur une face d'un autre substrat associé au premier dans un vitrage (double vitrage ou vitrage feuilleté). On peut aussi avoir un double vitrage du type verre/lame de gaz/verre avec sur la ou les faces extérieures des verres le revêtement photocatalytique et sur les faces internes (tournées vers la lame, de gaz) un empilement à une ou deux couches d'argent. Le même type de configuration s'applique aux feuilletés.

Le ou les autres revêtements fonctionnels peuvent être, notamment, un revêtement anti-salissures, anti-solaire, bas-émissif, chauffant, hydrophobe, hydrophile, antireflet, anti-statique un autre revêtement photocatalytique, On peut citer, notamment, les empilements anti-solaire ou bas-émissifs à une ou plusieurs couches d'argent, ou de nickel/chrome ou de nitrure de titane ou de zirconium. Dans le cas des couches à base de nitrure métallique, on peut utiliser une technique CVD.

L'invention sera décrite ci-après plus en détail avec des exemples de réalisation non limitatifs.

Les exemples 1 et 1 comparatif concernent le dépôt de couches de $TiO_2$ photocatalytique par pulvérisation cathodique.

**EXEMPLE 1** (hors invention)

On a déposé sur un verre clair silico-sodo-calcique, de 4 mm d'épaisseur, une première couche de SiOC par CVD, de 80 nm, puis une seconde couche de $TiO_2$ photocatalytique de 90 nm, (on peut aussi substituer à la couche de SiOC une couche de $SiO_2$ :Al obtenue par pulvérisation cathodique réactive à partir d'une cible de Si dopé Al.

La couche de $TiO_2$ a été déposée par pulvérisation cathodique assistée par champ magnétique. Il s'agit d'une pulvérisation réactive, en présence d'oxygène à partir d'une cible de titane. Le verre est préchauffé à une température d'environ 220°C à 250°C. Cette température est maintenue constante à 5° près pendant la pulvérisation de la couche, à l'aide d'un dispositif chauffant placé en regard de la cible.

La couche de $TiO_2$ obtenue a un indice de réfraction de 2,44. Elle est cristallisée sous forme anatase (elle peut comporter aussi des zones amorphes), avec une taille moyenne de cristallites inférieure à 25 nm.

Son activité photocatalytique a été quantifiée à l'aide d'un test utilisant l'acide palmitique : Il s'agit de déposer une épaisseur donnée d'acide palmitique sur un revêtement photocatalytique, à exploser celui-ci à un rayonnement U.V. centré sur 365 nm avec une puissance surfacique d'environ 50 W/m2 pendant toute la durée du test, puis à mesurer la vitesse de disparition de l'acide palmitique selon la relation suivante :

$$V\ (nm.h^{-1}) = [\text{épaisseur acide palmitique (nm)}]\ /\ [2 \times t_{1/2}\ \text{disparition (h)}]$$

Avec la couche selon l'invention on obtient par ce calcul une activité photocatalytique d'au moins 10 $nm.h^{-1}$, notamment d'au moins 20 $nm.h^{-1}$, notamment comprise entre 20 et 100 $nm.h^{-1}$, selon le choix des paramètres de dépôt du type pression, température.

Le verre ainsi revêtu des deux couches présente, selon l'Illuminant $D_{65}$, une réflexion lumineuse $R_L$ de 23%, avec des valeurs de a* et b* en réflexion, selon le système de colorimétrie (L, a*, b*) de l'ordre de 17 et 28 respectivement.

L'activité photocatalytique de la couche est donc intéressante, mais son aspect optique encore nettement réfléchissant, avec une couleur trop intense.

A noter qu'il est possible d'augmenter l'activité photocatalytique de la couche en lui faisant subir après dépôt un recuit conventionnel (d'une ou plusieurs heures à au moins 400°C).

**EXEMPLE 1 bis**

On répète l'exemple 1, mais cette fois la couche de $TiO_2$ est déposée sur un substrat non chauffé, puis traitée quatre heures à environ 500 à 550°C. En outre, la sous-couche en $SiO_2$ est épaissie jusqu'à 100 nm. La morphologie de la couche est un peu différente, avec une taille moyenne de cristallites plutôt supérieure à 30 nm.

Son activité photocatalytique est similaire à celle de la couche de l'exemple 1 sans recuit, mais lui est inférieure si on choisit une épaisseur moindre de sous-couche de $SiO_2$.

En conclusion, l'invention a mis au point un nouveau mode de dépôt sous vide de couches ne comprenant que du $TiO_2$ photocatalytique.

**Revendications**

1. Procédé de dépôt par pulvérisation cathodique d'un revêtement à propriétés photocatalytiques ne comprenant que de l'oxyde de titane, ledit oxyde de titane étant au moins partiellement cristallisé, notamment sous forme anatase sur un substrat porteur transparent ou semi-transparent du type verre, vitrocéramique, plastique, dans lequel on réalise la pulvérisation sous une pression de dépôt P d'au moins 2 Pa et d'au plus 6,67 Pa, **caractérisé en ce qu'**on réalise la pulvérisation à température ambiante et **en ce que** le dépôt du revêtement est suivi par un traitement thermique de type recuit afin d'obtenir la cristallisation du revêtement.

**2.** Procédé de dépôt selon la revendication 1, **caractérisé en ce que** la pression de dépôt P est d'au moins 2,67 Pa.

**3.** Procédé selon l'une des revendications précédentes, **caractérisé en ce que** le revêtement a un indice de réfraction supérieur à 2, notamment supérieur à 2,1, de préférence compris entre 2,15 et 2,35 ou entre 2,35 et 2,50.

**4.** Procédé selon l'une des revendications précédentes, **caractérisé en ce que** le revêtement contient des cristallites d'oxyde de titane de taille inférieure ou égale à 50 ou 40 nm, de préférence comprise entre 15 et 30 nm ou entre 20 et 40 nm.

**5.** Procédé de dépôt selon l'une des revendications précédentes, **caractérisé en ce que** le revêtement présente une rugosité RMS d'au moins 2 nm, notamment d'au plus 10 nm, de préférence comprise entre 2,5 et 7 nm ou entre 2,8 et 5 nm.

**6.** Procédé de dépôt selon l'une des revendications précédentes, **caractérisé en ce que** le revêtement a une épaisseur géométrique inférieure à 150 nm, notamment comprise entre 80 et 120 nm ou entre 10 et 25 nm.

**7.** Procédé de dépôt selon l'une des revendications précédentes, **caractérisé en ce qu'**on réalise la pulvérisation de façon réactive à partir d'une cible essentiellement métallique, ou de façon non réactive à partir d'une cible en céramique.

**8.** Procédé de dépôt selon la revendication 7, **caractérisé en ce qu'**on dope la cible à pulvériser par un métal, notamment choisi parmi Nb, Ta, Fe, Bi, Co, Ni, Cu, Ru, Ce, Mo, Al.

**9.** Procédé de dépôt selon l'une des revendications précédentes, **caractérisé en ce qu'**il est précédé et/ou suivi d'une étape de dépôt d'au moins une couche mince, notamment à fonction optique, anti-statique, anti-couleur, anti-réfléchissante, hydrophile, de protection ou pour amplifier la rugosité du revêtement à propriétés photocatalytiques, par une technique, de pulvérisation cathodique ou par une technique impliquant une décomposition thermique du type pyrolyse ou sol-gel.

**10.** Procédé de dépôt selon la revendication 9, **caractérisé en ce qu'**il est précédé par le dépôt d'au moins une couche mince par pyrolyse, notamment par CVD, ladite couche mince présentant une rugosité RMS d'au moins 5 nm, notamment d'au moins 10 nm.

**Claims**

**1.** A process for depositing a coating having photocatalytic properties by sputtering, said coating comprising only titanium oxide at least partly crystallized, especially in the anatase form on a transparent or semitransparent carrier substrate of the glass, glass-ceramic or plastic type, the sputtering being carried out at a deposition pressure P of at least 2 Pa and at most 6.67 Pa, **characterized in that** the sputtering is carried out ambient temperature, the deposition of the coating being followed by a heat treatment of the annealing type in order to crystallize the coating.

**2.** The deposition process as claimed in claim 1, **characterized in that** the deposition pressure P is at least 2.67 Pa.

**3.** The process as claimed in one of the preceding claims, **characterized in that** the coating has a refractive index greater than 2, especially greater than 2.1, preferably between 2.15 and 2.35 or between 2.35 and 2.50.

**4.** The process as claimed in one of the preceding claims, **characterized in that** the coating contains titanium oxide crystallites having a size of less than or equal to 50 or 40 nm, preferably between 15 and 30 nm or between 20 and 40 nm.

**5.** The deposition process as claimed in one of the preceding claims, **characterized in that** the coating has an RMS roughness of at least 2 nm, especially at most 10 nm, preferably between 2.5 and 7 nm or between 2.8 and 5 nm.

**6.** The deposition process as claimed in one of the preceding claims, **characterized in that** the coating has a geometrical thickness of less than 150 nm, especially between 80 and 120 nm or between 10 and 25 nm.

**7.** The deposition process as claimed in one of the preceding claims, **characterized in that** the sputtering is carried out in a reactive manner from an essentially metallic target, or in a nonreactive manner from a ceramic target.

**8.** The deposition process as claimed in claim 7, **characterized in that** the target to be sputtered is doped with a metal, especially one chosen from Nb, Ta, Fe, Bi, Co, Ni, Cu, Ru, Ce, Mo, Al.

**9.** The deposition process as claimed in one of the preceding claims, **characterized in that** it is preceded and/or followed by a step of depositing at least one thin layer, especially with an optical, antistatic, anticolor, antireflective, hydrophilic or protective function, or to increase the roughness of the coating having photocatalytic properties, by a sputtering technique or by a technique involving thermal decomposition of the pyrolysis type or by sol-gel.

**10.** The deposition process as claimed in claim 9, **characterized in that** it is preceded by the deposition of at least one thin layer by pyrolysis, especially by CVD, said thin layer having an RMS roughness of at least 5 nm, especially at least 10 nm.

**Patentansprüche**

**1.** Verfahren zum Aufbringen einer Beschichtung mit photokatalytischen Eigenschaften, die lediglich Titanoxid umfasst, durch Kathodenzerstäubung, wobei das Titanoxid wenigstens teilweise kristallisiertes Titanoxid, insbesondere in Form von Anatas ist, auf ein transparentes oder halbtransparentes Substrat vom Typ Glas, Glaskeramik oder Kunststoff, in welchem die Zerstäubung unter einem Beschichtungsdruck P von mindestens 2 Pa und höchstens 6,67 Pa durchgeführt wird, **dadurch gekennzeichnet, dass** die Zerstäubung bei Umgebungstemperatur durchgeführt wird, und dass auf das Aufbringen der Beschichtung eine Wärmebehandlung vom Typ Abkühlen im Kühlofen folgt, um die Kristallisation der Beschichtung zu erhalten.

**2.** Beschichtungsverfahren nach Anspruch 1, **dadurch gekennzeichnet, dass** der Beschichtungsdruck P mindestens 2,67 Pa beträgt.

**3.** Verfahren nach einem der vorhergehenden Ansprüche, **dadurch gekennzeichnet, dass** der Brechungsindex der Beschichtung mehr als 2, insbesondere mehr als 2,1, vorzugsweise 2,15 bis 2,35 oder zwischen 2,35 und 2,50 beträgt.

**4.** Verfahren nach einem der vorhergehenden Ansprüche, **dadurch gekennzeichnet, dass** die Beschichtung Titanoxidkristalle enthält, deren Größe weniger als oder gleich 50 oder 40 nm, vorzugsweise 15 bis 30 nm oder zwischen 20 und 40 nm beträgt.

**5.** Beschichtungsverfahren nach einem der vorhergehenden Ansprüche, **dadurch gekennzeichnet, dass** die Rautiefe RMS der Beschichtung mindestens 2 nm, insbesondere höchstens 10 nm, vorzugsweise 2,5 bis 7 nm oder zwischen 2,8 und 5 nm beträgt.

**6.** Beschichtungsverfahren nach einem der vorhergehenden Ansprüche, **dadurch gekennzeichnet, dass** die geometrische Dicke der Beschichtung weniger als 150 nm, insbesondere 80 bis 120 nm oder zwischen 10 und 25 nm beträgt.

**7.** Beschichtungsverfahren nach einem der vorhergehenden Ansprüche, **dadurch gekennzeichnet, dass** die Zerstäubung reaktiv mit einem im Wesentlichen metallischen Target oder nichtreaktiv mit einem keramischen Target durchgeführt wird.

**8.** Beschichtungsverfahren nach Anspruch 7, **dadurch gekennzeichnet, dass** das zu zerstäubende Target mit einem Metall dotiert ist, das insbesondere aus Nb, Ta, Fe, Bi, Co, Ni, Cu, Ru, Ce, Mo und Al ausgewählt ist.

**9.** Beschichtungsverfahren nach einem der vorhergehenden Ansprüche, **dadurch gekennzeichnet, dass** vor ihm und/oder nach ihm eine Stufe zum Aufbringen mindestens einer dünnen Schicht, insbesondere mit optischer, antistatischer, entfärbender, entspiegelnder, hydrophiler und schützender Funktion oder um die Rautiefe der Beschichtung mit photokatalytischen Eigenschaften zu vergrößern, durch eine Kathodenzerstäubungstechnik oder durch eine Technik stattfindet, an welcher eine thermische Zersetzung vom Typ Pyrolyse oder Sol-Gel beteiligt ist.

**10.** Beschichtungsverfahren nach Anspruch 9, **dadurch gekennzeichnet, dass** vor ihm das Aufbringen mindestens einer dünnen Schicht durch Pyrolyse, insbesondere durch CVD, stattfindet, wobei die Rautiefe RMS der dünnen Schicht mindestens 5 nm und insbesondere mindestens 10 nm beträgt.

**EP 1 319 092 B2**

## RÉFÉRENCES CITÉES DANS LA DESCRIPTION

**Documents brevets cités dans la description**

- WO 9710186 A